# EUROPEAN PATENT APPLICATION

(11) **EP 2 056 353 A2**
(43) Date of publication of application: **06.05.2009**
(21) Application number: 08164346.2
(22) Date of filing: 15.09.2008
(51) Int. Cl.: H01L 31/0232, H01L 31/042

(54) **Solar cell module**

(30) Priority: 02.11.2007 CN 200710167182
(71) Applicant: Delta Electronics, Inc., Taoyuan Hsien 333 (TW)
(72) Inventor: Chang, Hsuan-Hsi, 333, Taoyuan Hsien (TW); Lin, You-Sheng, 333, Taoyuan Hsien (TW)
(74) Representative: 2K Patentanwälte Blasberg Kewitz & Reichel

(57) **Abstract**

A solar cell module includes a solar cell unit and a light homogenizing unit. The light homogenizing unit has at least one optical element, which forms a light-input end, a hollow light tunnel and a light-output end. The light-output end is disposed adjacent to the solar cell unit.

## Description

### CROSS REFERENCE TO RELATED APPLICATIONS

This non-provisional application claims priority under Art. 87 of the European Patent Convention on Patent Application No(s). 200710167182.1 filed in the People's Republic of China on November 2, 2007, the entire contents of which are hereby incorporated by reference.

### BACKGROUND OF THE INVENTION

### Field of Invention

The present invention relates to a photoelectric conversion module and, in particular, to a solar cell module.

### Related Art

Solar power is one of the easily retrieved natural energy without producing pollution. Recently, it has become one of most popular alternative energies. The solar cell, which is a photoelectric device for converting energies, is usually used to convert the light energy into electric energy after being illuminated by solar light. However, when the solar light beam radiates on the solar cell, the area of the solar light beam is larger than the surface area of the solar cell, thereby lowering the density and utility rate of the solar light. Thus, a light-condensing unit is necessary in the solar cell to converge the solar light beam within a smaller area so as to obtain high density and utility rate of the solar light.

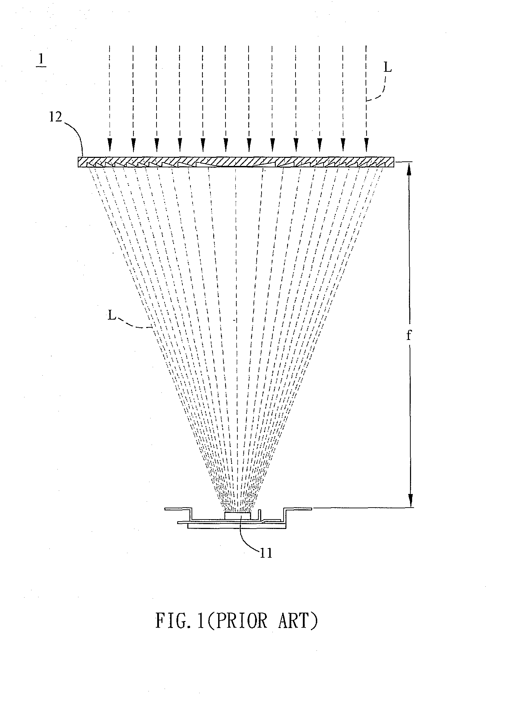

As shown in FIG. 1, a conventional solar cell module 1 includes a solar cell unit 11 and a concentric fresnel lens 12. The solar cell unit 11 is distant from the fresnel lens 12 with a focal length f, so that the solar cell unit 11 can receive the solar light beam L converged by the fresnel lens 12.

Since the solar light beam L is directly converged on the solar cell unit 11 by the fresnel lens 12, the solar cell unit 11 may be damaged by the strong energy of the converged solar light beam L. In addition, the fresnel lens 12 has a plurality of focal lengths, so that the converged solar light beam L may not homogeneously reach the solar cell unit 11. This will cause the leakage of the solar light beam L so as to reduce the entire photoelectric conversion rate of the solar cell module 1.

In addition, the tilt of the incident direction of the solar light beam L or the poor assembling of the solar cell module 1 may decrease the light condensing efficiency of the solar light beam L.

Therefore, it is an important subject to provide a solar cell module that can homogenize and then collect the converged solar light before it reaches the solar cell unit, thereby decreasing the light leakage and enhancing the light condensing efficiency.

### SUMMARY OF THE INVENTION

In view of the foregoing, the present invention is to provide a solar cell module that can homogenize and then collect the converged solar light before it reaches the solar cell unit, thereby decreasing the light leakage and enhancing the light condensing efficiency.

In addition, the present invention is also to provide a solar cell module that can homogenize the light with simplified module components, thereby decreasing the manufacturing cost.

To achieve the above, the present invention discloses a solar cell module including a solar cell unit and a light homogenizing unit. The light homogenizing unit includes at least one optical element having a light-input end, a hollow light tunnel and a light-output end. The light-output end is disposed adjacent to the solar cell unit, and the area of the light-output end is smaller than that of the light-input end.

As mentioned above, the solar cell module of the present invention has a light homogenizing unit, which includes a hollow light tunnel, disposed between a light-condensing unit and the solar cell unit. Thus, the energy of the collected light can be homogenized before the light enters the solar cell unit. Compared with the prior art, the present invention can converge the solar light and then homogenize it, so that the energy distribution of the light can be transformed from the focused energy distribution to the homogenized energy distribution. Accordingly, the light conversion and homogenization can be achieved so as to increase the entire light condensing efficiency of the solar cell module. In addition, since the light homogenizing unit has a hollow structure, the structure of the module components of the present invention can be simplified, thereby decreasing the manufacturing cost.

### BRIEF DESCRIPTION OF THE DRAWINGS

The present invention will become more fully understood from the subsequent detailed description and accompanying drawings, which are given by way of illustration only, and thus are not limitative of the present invention, and wherein:

FIG. 1 is a schematic illustration showing a conventional solar cell module;

FIG. 2 is a schematic illustration showing a solar cell module according to an embodiment of the present invention;

FIG. 3 is a schematic diagram showing the energy distribution of the light before and after passing through the light homogenizing unit of the present invention; and

FIG. 4 is a schematic diagram showing another solar cell module according to the embodiment of the present invention.

### DETAILED DESCRIPTION OF THE INVENTION

The present invention will be apparent from the following detailed description, which proceeds with reference to the accompanying drawings, wherein the same references relate to the same elements.

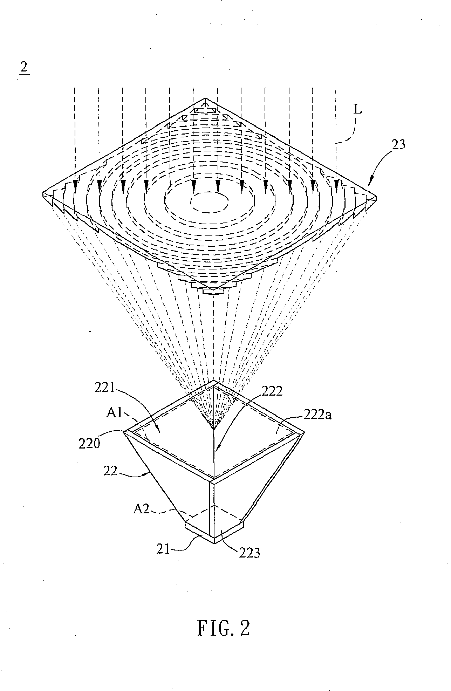

With reference to FIG. 2, a solar cell module 2 according to an embodiment of the present invention includes a solar cell unit 21 and a light homogenizing unit 22. The solar cell unit 21 has at least one solar cell element such as a substrate solar cell element or a thin film solar cell element. The material of the solar cell element can be III-V group compound such as gallium arsenide (GaAs), indium phosphide (InP), indium-gallium phosphide (InGaP), II-VI group compound such as cadmium telluride (CdTe), Copper Indium Diselenide (CuInSe₂), or IV group element such as silicon (Si).

The light homogenizing unit 22 includes at least one optical element 220, which forms a light-input end 221, a hollow light tunnel 222 and a light-output end 223. Alternatively, the optical element 220 can be a polygonal body. The light-output end 223 is disposed around the periphery of the solar cell unit 21 for avoiding the light leakage. In the embodiment, the light homogenizing unit 22 is a light pipe homogenizer, which is composed by four optical elements 220 forming a quadrilateral pyramid. The area A2 of the light-output end 223 is smaller than the area A 1 of the light-input end 221.

The optical elements 220 can be made of glass material or ceramic material. In the embodiment, the optical elements 220 are manufactured by molding or adhering so as to form the hollow light tunnel 222. The surface 222a of the light tunnel 222 can be formed with a high-reflective material or a dielectric material by film plating or coating so as to avoiding light leakage and thus increasing the light utility rate. Herein, the high-reflective material can be, for example but not limited to, aluminum or silver. Alternatively, the light homogenizing unit 22 can be formed by a reflective plate with a high-reflective material. Herein, the reflective plate can be integrally formed as a single unit to form the hollow light tunnel 222. The above-mentioned methods can both make the surface 222a of the light tunnel 222 have the high-reflective property.

In addition, the solar cell module 2 can further include a light-condensing unit 23 such as a light-condensing lens. In the embodiment, the light-condensing lens can include at least one fresnel lens such as a linear fresnel lens or a concentric fresnel lens. The light-condensing unit 23 is disposed adjacent to the light-input end 221 of the light homogenizing unit 22. In practice, the fresnel lens can have one or more focal lengths on the light-input end 221 of the light homogenizing unit 22.

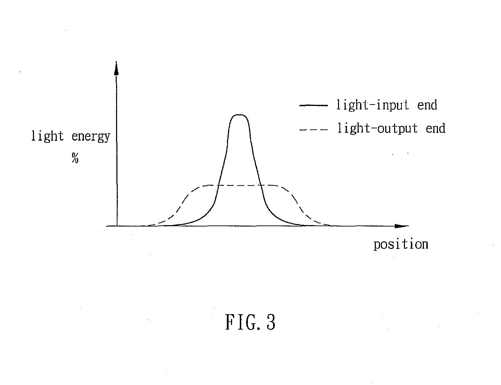

With reference to FIGS. 2 and 3, the solar light beam L is converged by the light-condensing unit 23 and then enters through the light-input end 221 of the light homogenizing unit 22. Then, the solar light beam L travels through the light tunnel 222 by total reflection, exits the light homogenizing unit 22 through the light-output end 223, and then enters the solar cell unit 21. To be noted, the energy distribution of the solar light beam L in the light-input end 221 is a focused energy distribution (Gauss energy distribution) as the solid line shown in FIG. 3, and the energy distribution of the solar light beam L in the light-output end 223 is a homogenized energy distribution as the dot line shown in FIG. 3. Therefore, the solar light beam L can be homogenized through the light homogenizing unit 22.

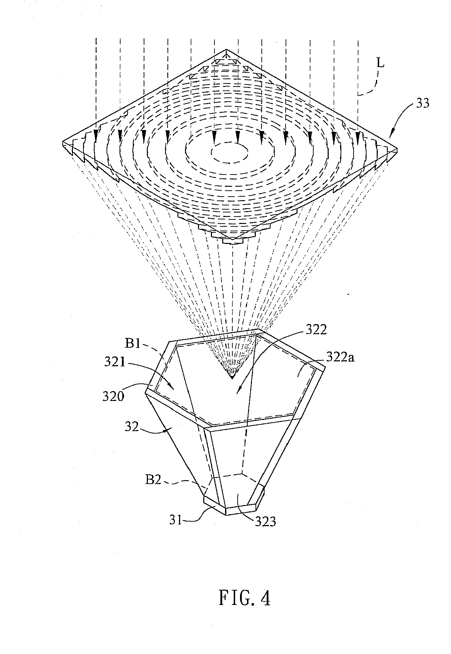

With reference to FIG. 4, another solar cell module 3 according to the embodiment of the present invention includes a solar cell unit 31, a homogenizing unit 32 and a light-condensing unit 33. The structure and functions of the light-condensing unit 33 are similar to those of the above-mentioned light-condensing unit 23, so the detailed description thereof will be omitted. In the embodiment, the solar cell unit 31 is hexagonal, and the light-input end 321, the hollow light tunnel 322 and the light-output end 323 of the light homogenizing unit 32, which is formed by the optical elements 320, are correspondingly hexagonal. The area B2 of the light-output end 323 is smaller than the area B1 of the light-input end 321. Therefore, the solar light beam L can be converged and then homogenized, thereby avoiding the light leakage. In addition, the light homogenizing unit 32 can tilt uniaxially corresponding to sun's travel direction.

In summary, the solar cell module of the present invention has a light homogenizing unit, which includes a hollow light tunnel, disposed between a light-condensing unit and the solar cell unit. Thus, the energy of the collected light can be homogenized before the light enters the solar cell unit. Compared with the prior art, the present invention can converge the solar light and then homogenize it, so that the energy distribution of the light can be transformed from the focused energy distribution to the homogenized energy distribution. Accordingly, the light conversion and homogenization can be achieved so as to increase the entire light condensing efficiency of the solar cell module, thereby increasing the efficiency and lifetime of the solar cell module. In addition, since the light homogenizing unit has a hollow structure, the structure of the module components of the present invention can be simplified, thereby decreasing the manufacturing cost.

As will become apparent to the person skilled in the art, in the solar cell module according to claim 3 the high-reflective material or the dielectric material can be formed by plating or coating. Furthermore, as will become apparent to the person skilled in the art, in the solar cell module according to claim 3 the high-reflective material can comprise aluminum or silver. As will become apparent to the person skilled in the art, in the solar cell module according to claim 7 the polygonal body can be a quadrilateral pyramid, a hexagonal pyramid or a trapezoid pyramid. As will become apparent to the person skilled in the art, in a solar cell module as outlined above the solar cell unit can comprise at least one solar cell element, and the solar cell element can be a substrate solar cell element or a thin film solar cell element. As will become apparent to the person skilled in the art, in a solar cell module as outlined above the solar cell unit can comprise at least one solar cell element, and a material of the solar cell element comprises gallium arsenide (GaAs), indium phosphide (InP), indium-gallium phosphide (InGaP), cadmium telluride (CdTe), Copper Indium Diselenide (CuInSe2) or silicon (Si).

Although the present invention has been described with reference to specific embodiments, this description is not meant to be construed in a limiting sense. Various modifications of the disclosed embodiments, as well as alternative embodiments, will be apparent to persons skilled in the art. It is, therefore, contemplated that the appended claims will cover all modifications that fall within the true scope of the present invention.

## Claims

1. A solar cell module comprising:
a solar cell unit (21; 31); and
a light homogenizing unit (22; 32) having a light-input end (221; 321), a hollow light tunnel (222; 322) and a light-output end (223; 323), wherein the light-output end is disposed adjacent to the solar cell unit.

2. The solar cell module according to claim 1, wherein an area of the light-output end (223; 323) is smaller than that of the light-input end (221; 321).

3. The solar cell module according to claim 1 or 2, wherein an inner surface of the light tunnel (222; 322) comprises a high-reflective material or a dielectric material.

4. The solar cell module according to any of the preceding claims, wherein the light homogenizing unit (22; 32) comprises at least an optical element (220; 320).

5. The solar cell module according to claim 4, wherein the optical element is made of a glass material or a ceramic material and is manufactured by molding or adhering.

6. The solar cell module according to claim 4 or 5, wherein the optical element comprises a reflective plate with a high-reflective material, and the reflective plate is integrally formed as a single unit to form the light tunnel.

7. The solar cell module according to any of the preceding claims, wherein the light homogenizing unit (22; 32) has a polygonal body.

8. The solar cell module according to claim 1, further comprising a light-condensing unit (23; 33) disposed at the light-input end of the light homogenizing unit.

9. The solar cell module according to claim 8, wherein the light-condensing unit is a light-condensing lens unit.

10. The solar cell module according to claim 9, wherein the light-condensing lens unit comprises at lease one fresnel lens.

11. The solar cell module according to claim 10, wherein the fresnel lens has one or more focal lengths at the light-input end of the light homogenizing unit.

12. The solar cell module according to claim 10 or 11, wherein the fresnel lens is a linear fresnel lens or a concentric fresnel lens.

13. The solar cell module according to any of the preceding claims, wherein an energy distribution of light at the light-input end of the light homogenizing unit is a focused energy distribution, and an energy distribution of light at the light-output end of the light homogenizing unit is a homogenized energy distribution.

14. The solar cell module according to any of the preceding claims, wherein the light-output end of the light homogenizing unit is disposed around the periphery of the solar cell unit.

15. The solar cell module according to any of the preceding claims, wherein the light homogenizing unit tilts uniaxially corresponding to sun's travel direction.
